# EUROPEAN PATENT APPLICATION

(11) **EP 4 565 050 A1**
(43) Date of publication of application: **04.06.2025**
(21) Application number: 23213320.7
(22) Date of filing: 30.11.2023
(51) Int. Cl.: H10N 60/01, H10N 60/80

(54) **OPTIMIZED TRANSITION FOR SUPERCONDUCTING LINES**

(71) Applicant: Dyconex AG, 8303 Bassersdorf (CH)
(72) Inventor: Neubauer, Birgit, 72160 Horb (DE); Hauer, Marc Robert, 8610 Uster (CH); Mäder, Thomas, 1315 Sarraz (CH); Kadrija, Xhevahir, 8303 Bassersdorf (CH)
(74) Representative: Schulz Junghans Patentanwälte PartGmbB

(57) **Abstract**

A method for producing an electrically conducting structure (1), wherein the method comprises the steps of: providing an electrically insulating substrate (4) comprising a first side (4a), and sputtering, in a sputtering chamber, a first metal onto the first side (4a) of the substrate (4) to generate a first metallic layer (30) for superconducting an electrical current, and subsequently sputtering a second metal in said sputtering chamber onto the sputtered first metallic layer (31) to generate a second metallic layer.

## Description

The present invention relates to an electrically conducting structure that is capable of superconducting an electric current at a certain temperature depending on the specific current conducting material.

In certain applications, superconducting lines are needed at low temperatures. Currently, these lines are realized by single cables. In certain applications niobium (Nb) is used as superconducting metal. Particularly, niobium is an elemental type-II superconductor and has a transition temperature of 9.26 K.

Conventionally, niobium is often sputtered onto existing copper conductors. As this forms an oxide layer in air, it results in an increased contact or transition resistance. However, this resistance is undesirable for superconducting structures.

Based on the above, the problem to be solved by the present invention is to provide an improved electrically conducting structure for superconducting an electrical current and a corresponding method for manufacturing such a structure that are improved regarding the above-stated disadvantage.

According to the present invention, this problem is solved by a method for producing an electrically conducting structure. Further aspects of the present invention relate to an electrically conducting structure for superconducting an electrical current as well as to a device comprising such a structure and a use of the electrically conducting structure according to the present invention. Embodiments of these aspects of the present invention are stated in the corresponding dependent claims and are described below.

According to claim 1, a method for producing an electrically conducting structure is disclosed, comprising at least one first conductor structure arranged thereon for superconducting of an electrical current, wherein the method comprises the steps of:
- providing an electrically insulating substrate comprising a first side, and
- depositing, in a vacuum chamber, by vacuum deposition, a first metal onto the first side of the substrate to generate a first metallic layer forming the at least one first conductor structure, and subsequently depositing, by vacuum deposition, a second metal in said vacuum chamber on the deposited first metallic layer.

Advantageously, by depositing the first metal directly onto the electrically insulating substrate and subsequently depositing the second metal on the first metal, the formation of any oxide of the second metal (and particularly any oxide of the first metal) at an interface between the first metallic layer and the second metallic layer may be significantly reduced or prevented.

The term "vacuum deposition" is used in its meaning known to and used by the person skilled in the art. It particularly refers to a process to deposits layers of material, particularly atom-by-atom or molecule-by-molecule, on a solid surface at pressures below the atmospheric pressure. Common vacuum depositions techniques are physical vapor deposition techniques, such as sputtering, vacuum evaporation, ion-beam plating, and arc deposition, including variants that confer an enhanced degree of ionisation and energy to the coating to yield improved properties, for example high-power impulse magnetron sputtering (HiPIMS) and ion-beam-assisted deposition (IBAD), and chemical vapor deposition techniques, in which the solid surface is exposed to volatile precursors to the material to be deposited, which reacts on the surface to the desired deposit.

According to one embodiment of the method, the first metal and the second metal is deposited by physical vapor deposition, including but not limited to sputtering, vacuum evaporation, ion-beam plating, and arc deposition. Such physical vapor deposition is particularly advantageous for depositing a desired material on temperature-sensitive substrates, e.g., consisting of or comprising a polymer. Accordingly, the electrically insulating substrate essentially consists of or comprises a polymer in one embodiment. According to another embodiment, the first metal and the second metal is deposited by chemical vapor deposition. For example, the first metal may be niobium and may be deposited by applying a precursor of niobium, e.g., a niobium salt such as NbCls, as a vapor to the electrically insulating substrate, wherein on the substrate the niobium salt is reduced in presence of a reducing agent, e.g., elemental hydrogen, to metallic niobium. Chemical vapor deposition may be applied to thermally stable substrates, e.g., consisting of or comprising a ceramic and/or a glass. Accordingly, the electrically insulating substrate essentially consists of or comprises a ceramic and/or a glass in one embodiment.

Accordingly, in one embodiment of the method, the method comprises the steps of:
- providing an electrically insulating substrate comprising a first side, and
- sputtering, in a sputtering chamber, a first metal onto the first side of the substrate to generate a first metallic layer of the at least one conductive track, and subsequently sputtering a second metal in said sputtering chamber on the sputtered first metallic layer.

Particularly, according to an embodiment, the first metal is niobium (Nb) or titanium (Ti) and the second metal is copper (Cu).

Particularly, depositing, particularly sputtering, the first metal and the second metal comprises generating a vacuum in the vacuum chamber, wherein in the vacuum chamber with the generated vacuum the first metal is deposited, particularly sputtered, on the first side of the substrate to generate the first metallic layer forming the least one first conductor structure on the first side of the substrate, and subsequently, without opening the vacuum chamber (i.e. without breaking the vacuum in the sputtering chamber), the second metal is deposited, particularly sputtered in said vacuum chamber on the deposited, particularly sputtered, first metallic layer so as to reduce or prevent the formation of an oxide of the second metal between the first metallic layer and the second metallic layer.

Particularly, the electrically conducting structure may be based on a printed circuit board substrate that, e.g., combines conventional copper conductors (second metal) with superconducting conductors (first metal), e.g., niobium or titanium.

Particularly, the transition from the second metal (e.g., copper conductors) to the first metal (e.g. niobium conductors) is optimized so that the contact resistance is as small as possible. This resistance becomes relevant only at temperatures at which the niobium becomes superconducting. By sputtering the superconducting layer (i.e., first metal, e.g., Nb) together with the second metal (e.g., copper), without exposure to air, no oxide is formed at the interface and the contact resistance is optimized.

According to an embodiment of the method, the electrically insulating substrate is provided with a metallic covering layer, e.g., formed out of or comprising, e.g. copper, wherein the metallic covering layer is arranged on the first side of the electrically insulating substrate, and wherein prior to said depositing, particularly sputtering, of the first and second metallic layer a part of the metallic covering layer is removed from the first side of the electrically insulating substrate, resulting particularly in a remaining portion of the metallic covering layer. Upon removal, one or more exposed portions of the substrate are generated onto which the first metallic layer is deposited, particularly sputtered, and subsequently the second metallic layer. Additionally or alternatively, the electrically insulating substrate is provided with a metallic covering layer, e.g., formed out of or comprising, e.g., copper, in an embodiment, wherein the metallic covering layer is arranged on a second side of the electrically insulating substrate, the second side facing away from the first side of the electrically insulating substrate.

Advantageously, by removing or lifting off a part of the metallic covering layer from the first side of the electrically insulating substrate, one or more parts of the electrically insulating substrate are exposed for subsequently depositing, particularly sputtering, the first metal onto those exposed parts of the substrate, wherein particularly the lifting off yields in a roughened surface of the substrate which improves adhesion of the deposited, particularly sputtered, first metal. In addition, at least one second conductor structure may be formed in the same step of removing lifting off, wherein the at least one second conductor structure is formed by the remaining portion of the metallic covering layer. Furthermore, by depositing, particularly sputtering, the first metal on the exposed substrate surface, particularly after removing or lifting off, one or parts of the metallic covering layer, a butt joint between the first metal and remaining portion of the covering layer or the at least one second conductor structure, respectively, may be formed, wherein particularly the butt joint is substantially gap-free, wherein by way of the formed butt joint the transition impedance between the first metal and the metallic covering layer may be effectively reducing.

Furthermore, according to an embodiment of the method, prior to said depositing, particularly sputtering, of the first and second metallic layer, at least one recess is formed into the electrically insulating substrate, wherein particularly the recess is a through-hole extending through the electrically insulating layer and particularly through the metallic covering layer arranged on the first side of the electrically insulating substrate. Particularly the recess / through-hole is used to establish an electrical contact between the two sides of the substrate.

Furthermore, according to an embodiment of the method, prior to said depositing, particularly sputtering,
- a photoresist layer is applied to the metallic covering layer arranged on the first side of the electrically insulating substrate prior to said depositing, particularly sputtering, of the first and second metallic layer,
- the photoresist layer is selectively exposed to light, e.g., by way of using a mask layer covering one or regions of the photoresist layer, and treated with a developing agent, wherein one or more regions of the photo resist layer are removed to exposed one or portions of the metallic cover layer,
- an etchant is applied to the metallic covering layer, wherein the one or more exposed regions of the metallic covering layer are removed resulting a remaining portion of the metallic covering layer, wherein one or more portions of the first side of the electrically insulating substrate are exposed.

Particularly, a photoresist layer is applied to the covering layer arranged on the first side of the electrically insulating substrate prior to said depositing, particularly sputtering, of the first and second metallic layer, wherein particularly said photo resist layer covers the at least one recess. Furthermore, a mask film is arranged on the photoresist layer, wherein the mask film covers a region of the photoresist layer and leaves an adjacent region unmasked, and wherein light is applied to the unmasked adjacent region, and wherein after removing the mask layer, a developing agent is applied to the photoresist layer to remove one of said two regions to expose a portion of the metallic covering layer arranged on the first side of the electrically insulating substrate, and wherein an etching agent is applied to the exposed portion of the metallic covering layer arranged on the first side of the electrically insulating substrate to remove the exposed portion of the covering layer and thereby expose a portion of the first side of the electrically insulating substrate. The photoresist layer may be kept or maintained for the step of depositing, particularly sputtering, the first metal onto the exposed portions of the first side of the electrically insulating substrate.

Furthermore, according to an embodiment of the method, the first metal is deposited, particularly sputtered, onto said exposed portion of the first side of the electrically insulating substrate to form the first metallic layer (and thus the at least one first conductor structure) on said exposed portion of the first side of the electrically insulating substrate.

Furthermore, in an embodiment of the method, a remainder of the photoresist layer (particularly with deposited, particularly sputtered, first and second metal thereon) is removed from the metallic covering layer arranged on the first side of the electrically insulating substrate after said depositing, particularly sputtering, of said first and second metal.

Furthermore, in an embodiment of the method, after removal of said remainder of the photoresist layer, a plated metal layer is arranged on the second metallic layer and on at least a portion of the remaining covering layer arranged on the first side of the electrically insulating substrate, by galvanically plating the second metallic layer and said at least one portion of the metallic covering layer arranged on the first side of the electrically insulating substrate with a metal (as plating material). Particularly, in an embodiment, the metal is copper (Cu).

Particularly, the plated metal layer is arranged on the transition region between the remaining covering layer and the first metallic layer, in which the butt joint is formed between the remaining layer and the first metallic layer. Advantageously, the plated metal layer reinforces the transition region or butt joint, respectively, particularly the mechanical integrity of the transition region or butt joint, respectively.

Furthermore, according to an embodiment of the method, after said galvanic plating
- a further photoresist layer is applied on the plated metal layer,
- the further photoresist layer is selectively exposed to light, e.g., by way of using a mask layer covering one or regions of the photoresist layer, and treated with a developing agent, wherein a region of the further photoresist layer is removed to expose a portion of the plated metal layer, and
- an etchant is applied to the plated metal layer to remove the exposed portion of the plated metal layer and a portion of the second metallic layer arranged below the exposed portion of the plated metal layer, wherein a portion of the first metallic layer and/or at least a portion of the first side of the electrically insulating substrate is exposed.

Particularly, after said galvanically plating, a further photoresist layer is applied to the plated metal layer. Furthermore, a further mask film is arranged on the further photoresist layer, wherein the further mask layer covers a region of the further photoresist layer and leaves an adjacent region of the further photoresist layer unmasked, and wherein light is applied to the unmasked adjacent region of the further photoresist layer, and wherein after removing the further mask layer a developing agent is applied to the further photoresist layer to remove one of said two regions of the further photoresist layer to expose a portion of the plated metal layer, and wherein an etching agent is applied to the exposed portion of the plated metal layer to remove the exposed portion of the plated metal layer and a portion of the second metallic layer arranged below the exposed portion of the plated metal layer to expose at least a portion of the first metallic layer and/or to expose a portion of the first side of the electrically insulating substrate.

Particularly, the exposed portion of the first metallic layer is particularly suited for conducting a current as a superconductor, since particularly under the critical temperature of the superconductor, the current flows only on the surface of the superconductor. Particularly, the path length for conducting a current under superconducting condition may be adjusted by the length of the exposed portion of the first metallic layer.

According to an embodiment of the method according to the present invention, the first metal is one of: niobium (Nb), titanium (Ti), wherein thus the at least one first conductor structure essentially consists of or comprises niobium or titanium. In one embodiment, the second metal is copper (Cu). In one embodiment, the metallic covering layer, and thus the at least second conductor structure, essentially consists of or comprises copper (Cu). In one embodiment, the plated metal layer essentially consists of or comprises copper (Cu).

Furthermore, according to a preferred embodiment, the substrate is formed out of or comprises one of the following materials: a liquid crystal polymer, a polyimide.

According to a preferred embodiment of the method according to the present invention, the first metal is Niobium (Nb) or titanium (Ti), the second metal is copper (Cu), the metallic covering layer essentially consists of or comprises copper (Cu) and the plated metal layer essentially consists of or comprises copper (Cu).

According to a further embodiment of the method, the first metallic layer is characterized by thickness in the range of 0.05 µm to 1.5 µm. In one embodiment, the covering layer or the at least one second conductor structure is characterized by a thickness in the range of 5 µm to 50 µm, particularly 5 µm to 36 µm.

According to a further aspect of the present invention, an electrically superconducting structure is disclosed that is manufactured using the method according to the present invention.

Furthermore, according to yet another aspect of the present invention, an electrically conducting structure for superconducting an electrical current is disclosed, comprising:
- an electrically insulating substrate comprising a first side and a second side facing away from the first side,
- at least one first conductor structure for superconducting an electrical current, the at least one first conductor structure being arranged on the first side of the substrate, wherein the at least one conductive track comprises a sputtered first metallic layer of a first metal arranged on the first side of the substrate,
- a sputtered second metallic layer of a second metal that is different from the first metal, the second metallic layer being arranged on the first metallic layer.

Particularly, the first metallic layer of the first metal forming the at least one first conductor structure is arranged directly on the electrically insulating substrate, i.e. without any material layer between the first metallic layer and the substrate.

Particularly, in an embodiment, the first metal is niobium (Nb) or titanium (Ti), and the second metal is copper (Cu).

According to an embodiment of the electrically conducting structure, the first metallic layer is partially overlapped by the second metallic layer so that the first metallic layer comprises an exposed portion.

Furthermore, according to an embodiment of the electrically conducting structure, at least one second conductor structure, e.g., formed out of or comprising copper, is arranged on the first side of the electrically insulating substrate. In one embodiment, the at least one first conductor structure and the at least one second conductor (40a) structure about each other by a butt j oint. In one embodiment, a metallic covering layer formed out of or comprising a metal, e.g., copper, is arranged on the second side of the electrically insulating substrate.

Further, in an embodiment of the electrically conducting structure, the second metallic layer and/or the at least one second conductor structure arranged on the first side of the electrically insulating substrate is covered by a plated metal layer of a metal. Particularly, in an embodiment, the metal is copper (Cu).

Particularly, the first and second metal, the at least one second conductor structure and the plated metal layer may be the material as described above in conjunction with the method according to the present invention. These selections of materials apply to the electrically conducting structure according to the present invention as well.

According to yet another aspect of the present invention, a device is disclosed, the device comprising an electrically conducting structure according to the present invention, wherein particularly the device is a quantum computer or a medical device.

According to yet another aspect of the present invention, a use of an electrically conducting structure according to the present invention for superconducting an electrical current in a quantum computer is disclosed.

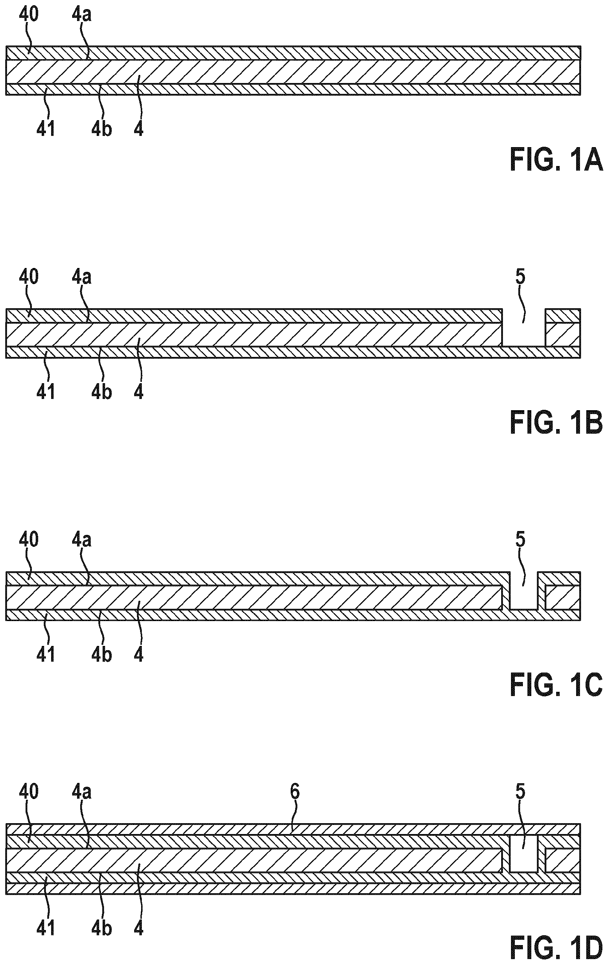

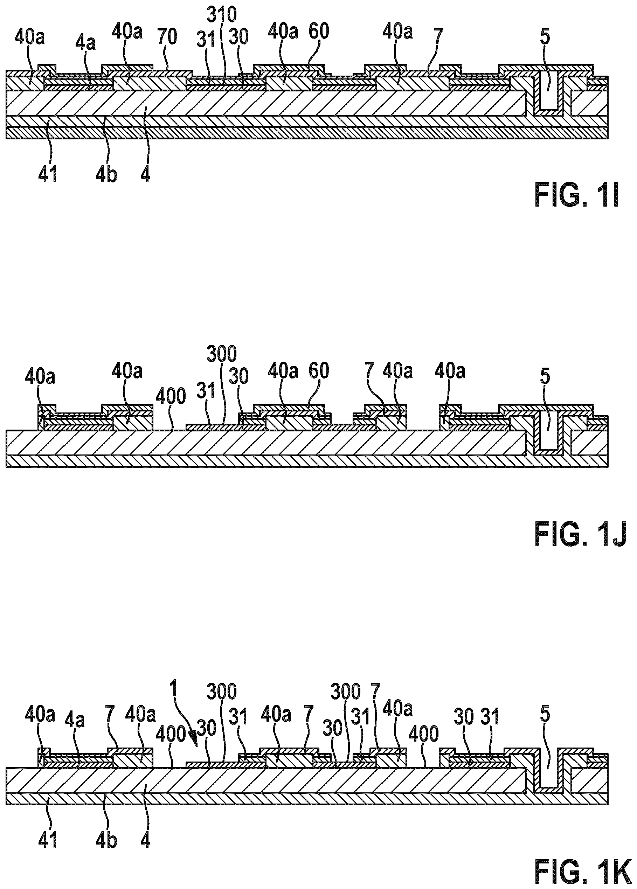

In the following, embodiments as well as further features and advantages of the present invention shall be described with reference to the Figures, wherein
- Fig 1A to 1K: show an embodiment of a method according to the present invention for producing an electrically conducting structure for superconducting an electrical current; an embodiment of the electrically conducting structure according to the present invention is shown in Fig. 1K.

Fig. 1A to 1K show an embodiment of a method for manufacturing an electrically conducting structure 1 according to the present invention, wherein Fig. 1K shows a cross-sectional view of an embodiment of the finished structure 1. The structure 1 serves for superconducting an electrical current. Particularly, the electrically conducting structure 1 comprising an electrically insulating substrate 4 comprising a first side 4a and a second side 4b facing away from the first side 4a. Furthermore, the structure 1 comprises at least one first conductor structure 30 for superconducting an electrical current, the at least one first conductor structure being arranged on the first side 4a of the substrate 4, wherein the at least one conductive track comprises or is formed by a first metallic layer 30 of a first metal arranged on the first side 4a of the electrically insulating substrate 4, and wherein the structure comprises a second metallic layer 31 of a second metal, the second metallic layer 31 being arranged on the first metallic layer 30. Particularly, the first metallic layer 30 is deposited or arranged directly on the electrically insulating substrate, i.e. without any material layer between the first metallic layer 30 and the substrate 4. The structure 1 further comprises at least one second conductor structure 40a arranged on the first side 4a of the electrically insulating substrate 4. Particularly, the at least one first conductor structure 30 and the at least one second conductor structure 40a are arranged such on the first side 4a that both abut, and thus electrically contact, to each other by a butt joint. Particularly, the first metal is niobium (Nb) and the second metal is copper (Cu). In the following the invention is described with respect to these two metals Nb and Cu, but other metals may also be used as described herein, e.g., titanium (Ti) instead of niobium.

Fig. 1A to 1K further illustrate an embodiment of a method for producing the structure 1. Particularly, the method comprises to completely remove the covering layer 40 comprised of copper from the electrically insulating substrate 4 in those areas where the superconducting niobium layer 30 is to be deposited. Then, the niobium is sputtered directly onto the first side 4a of the electrically insulating substrate 4 to generate the first metallic layer, here a niobium layer. Without breaking the vacuum, another copper layer 31 - the second metallic layer - Is deposited thereon. Subsequently, the second metallic layer 31 (e.g., copper layer) on the niobium layer 30 is galvanically reinforced by plated copper layer 7. In a final etching step, the unneeded copper, i.e. of the covering layer 40, of the sputtered second metallic layer 31, and of the plated layer 7, is removed. The niobium layer (first metallic layer) 31 is thereby at least partially exposed. Furthermore, by removing a part of the covering layer as described above, the remaining part of the covering layer 40a may form the at least one second conductor structure 40a stated above. Also, by sputtering the niobium onto the areas, where the covering layer 40 was removed, the above mentioned butt joint between the first metallic layer 30 and the at least second conductor structure 40a may be formed.

In detail, the method for producing the electrically conducting structure 1 may comprise the following steps. Initially, particularly, the electrically insulating substrate 4 is provided (cf. Fig. 1A), the substrate 4 comprising a first side 4a and a second side 4b that faces away from the first side 4a. Furthermore, a covering layer 40 formed out of or comprising copper is provided on the first side 4a of the substrate 4. Likewise, a covering layer 41 formed out of or comprising copper may be provided on the second side 4b of the substrate 4, too.

Furthermore, at least one recess 5, particularly in form of a through-hole 5, is formed into the substrate 4, so that the recess 5 extends through the electrically insulating substrate 4 and particularly through the covering layer 40 arranged on the first side 4a of the substrate 4 (cf. Fig. 1B). Furthermore, an inside of the through-hole 5 is also covered with copper to provide an electrical connection between the first side 4a and the second side 4b of the substrate 4 (cf. Fig. 1C).

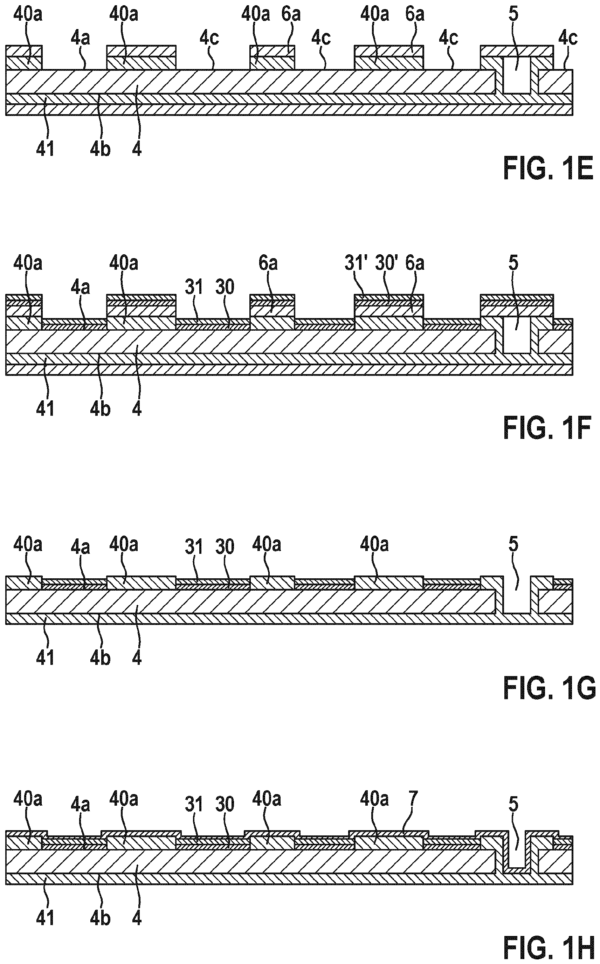

Further, a photoresist layer 6 is applied to the covering layer 40 arranged on the first side 4a of the substrate 4 (cf. Fig. 1D). Afterwards, a mask film is arranged on the photoresist layer 6 to cover at least a region of the photoresist layer 6, wherein at least one adjacent region of the photoresist layer 6 is left unmasked. Particularly, in this way, the mask film allows to generate a desired pattern of the covering layer 40, and thus later the at least second conductor structure 40a. To this end, light is applied to the at least one unmasked adjacent region, and after removing the mask layer a developing agent is applied to the photoresist layer 6 to remove one of said two regions (depending on whether the photoresist is a positive or negative photoresist) to expose at least a portion of the covering layer 40 arranged on the first side 4a of the substrate 4. Furthermore, an etching agent is applied to the at least one exposed portion of the covering layer 40 to remove the at least one exposed portion of the covering layer 6 and thereby expose at least one portion 4c of the first side 4a of the electrically insulating substrate 4 as shown in Fig. 1E. Likewise, the remaining portion 40a of the covering layer may form the at least one second conductor structure 40a.

Now, the first metal, here niobium, is sputtered onto said at least one exposed portion 4c of the first side 4a of the electrically insulating substrate 4 to form the first metallic layer 30, i.e., niobium layer, on said at least one exposed portion 4c of the first side 4a of the electrically insulating substrate 4. This sputtering is conducted in a sputtering chamber, wherein a second metal (here particularly copper) is directly sputtered onto the niobium layer 30 without breaking the vacuum in the sputtering chamber. This allows to subsequently generate the second metallic layer 31 formed out of copper directly on the niobium layer 30 in the absence of oxygen, thereby reducing formation of any oxide of the second metal at an interface between the first metallic layer 30 and the second metallic layer 31 (cf. Fig. 1F).

Thereafter, a remainder 6a of the photoresist layer 6 (particularly with sputtered first and second metallic layer 30', 31' thereon) is removed from the covering layer 40 or remaining portion 40a of the covering layer 40, respectively, arranged on the first side 4a of the electrically insulating substrate 4 as shown in Fig. 1G.

After removal of said remainder 6a of the photoresist layer 6, a plated metal layer 7 is arranged on the second metallic layer 31 (e.g. copper layer) and on the covering layer 40 or remaining portion 40a of the covering layer 40, respectively, arranged on the first side 4a of the electrically insulating substrate 4, by galvanically plating the second metallic layer 31 and the covering layer 40 or remaining portion 40a of the covering layer 40, respectively, with copper to reinforce said layers 31, 40 or portion 40a (cf. Fig. 1H) and particularly the butt joint between the first metallic layer 30 and the remaining portion 40a of the covering layer 40.

After said galvanically plating, a further photoresist layer 60 is applied to the plated metal (e.g. copper) layer 7. A further mask film is arranged on the further photoresist layer 60 to pattern the plated copper layers 7 and the copper layers 40, 31 or remining portion 40a of copper layer 40, respectively, thereunder. Particularly, the further mask layer covers at least a region of the further photoresist layer 60 and leaves at least an adj acent region of the further photoresist layer 60 unmasked. As described before, light is applied to the at least one unmasked adjacent region, and after removing the further mask layer a developing agent is applied to the further photoresist layer 60 to remove one of said two regions to expose at least portion 70 of the plated metal layer 7 (cf. Fig. 1I). An etching agent is applied to the at least one exposed portion 70 of the plated metal layer 7 to remove the at least one exposed portion of the plated metal layer 7 and a corresponding portion of the second metallic layer 31 arranged below the at least one exposed portion of the plated metal layer 7 to expose at least a portion 300 of the first metallic layer 30 and/or to expose at least a portion 400 of the first side 4a of the substrate 4 as shown in Fig. 1I.

Particularly, the advantage of the solution according to the present invention is that formation of oxide layer between the copper and the niobium. Furthermore, the niobium layer / conductor 30 runs undisturbed on the surface of the first side 4a of the substrate 4 and does not have to be sputtered along the edge of the copper, over a step, which is conducive to mechanical reliability. Thus, a better contact or transition resistance is achieved.

## Claims

1. A method for producing an electrically conducting structure (1), wherein the method comprises the steps of:
- providing an electrically insulating substrate (4) comprising a first side (4a), and
- depositing, in a vacuum chamber, by vacuum deposition, particularly sputtering, a first metal onto the first side (4a) of the substrate (4) to generate a first metallic layer (30) forming a first conductor structure (30) for superconducting an electrical current, and subsequently depositing, by vacuum deposition, particularly sputtering, a second metal in said vacuum chamber onto the deposited, particularly sputtered, first metallic layer (30) to generate a second metallic layer (31)

2. The method according to claim 1, wherein the electrically insulating substrate is provided a metallic covering layer (40) being arranged on the first side (4a) of , wherein prior to said depositing, particularly sputtering, of the first and second metallic layer (30, 31) a part of the metallic covering layer (40) is removed from the first side (4a) of the electrically insulating substrate (4).

3. The method according to claim 2, wherein after removing a part of the metallic covering layer (40) on the first side (4) of the substrate (4) a resulting remaining portion (40a) of the metallic covering layer (40) forms a second conductor structure (40a), wherein the first metallic layer (30) and the second conductor structure (40a) are electrically contacting each other via a butt joint after depositing, particularly sputtering, of the first metallic layer (30).

4. The method according to any one of the preceding claims, wherein prior to said depositing, particularly sputtering, of the first and second metallic layer (30, 31) at least one recess (5) is formed into the electrically insulating substrate (4), wherein particularly the recess (5) is a through-hole extending through the electrically insulating substrate (4) and particularly through the metallic covering layer (40) arranged on the first side (4a) of the electrically insulating substrate (4).

5. The method according to any one of claims 2 to 4, wherein
- a photoresist layer (6) is applied to the metallic covering layer (40) arranged on the first side (4a) of the electrically insulating substrate (4) prior to said depositing, particularly sputtering, of the first and second metallic layer (30, 31),
- the photoresist layer (6) is selectively exposed to light, e.g., by way of using a mask layer covering one or regions of the photoresist layer (6), and treated with a developing agent, wherein one or more regions of the photo resist layer (6) are removed to exposed one or portions of the metallic cover layer (40),
- an etchant is applied to the metallic covering layer (40), wherein the one or more exposed regions of the metallic covering layer (40) are removed resulting a remaining portion (40a) of said metallic covering layer (40), wherein one or more portions (4c) of the first side (4a) of the electrically insulating substrate (4) are exposed.

6. The method according to claim 5, wherein the first metal is deposited, particularly sputtered, onto said exposed portion (4c) of the first side (4a) of the electrically insulating substrate (4) to form the first metallic layer (30) on said exposed portion (4c) of the first side (4a) of the electrically insulating substrate (4).

7. The method according to one of the claims 4 to 6, wherein a remainder (6a) of the photoresist layer (6) is removed from the remaining portion (40a) of said metallic covering layer (40) arranged on the first side (4a) of the electrically insulating substrate (4) after said depositing, particularly sputtering, of said first and second metallic layer (30, 31).

8. The method according to claim 7, wherein after removal of said remainder (6a) of the photoresist layer (6) a plated metal layer (7) is arranged on the second metallic layer (31) and the remaining portion (40a) of said metallic covering layer (40) arranged on the first side (4a) of the electrically insulating substrate (4), particularly by galvanically plating the second metallic layer (31) and the remaining portion (40a) of said metallic covering layer (40) arranged on the first side (4a) of the electrically insulating substrate (4).

9. The method according to claim 8, wherein after said galvanically plating,
- a further photoresist layer (60) is applied on the plated metal layer (7),
- the further photoresist layer (60) is selectively exposed to light, and treated with a developing agent, wherein a region of the further photo resist layer (60) is removed to expose a portion (70) of the plated metal layer (7),
- an etchant is applied to the plated metal layer (7) to remove the exposed portion (70) of the plated metal layer and a portion (310) of the second metallic layer (31) arranged below the exposed portion (70) of the plated metal layer (7), wherein a portion (300) of the first metallic layer (30) and/or at least a portion (400) of the first side (4a) of the electrically insulating substrate (4) is exposed..

10. The method according to one of the preceding claims, wherein the first metal is one of: niobium (Nb), titanium (Ti); and/or wherein the second metal is copper (Cu); and/or wherein the metallic covering layer (40, 41) essentially consists of or comprises copper (Cu); and/or wherein the plated metal layer essentially consists of or comprise copper (Cu).

11. An electrically conducting structure for superconducting an electrical current, comprising:
- an electrically insulating substrate (4) comprising a first side (4a) and a second side (4b) facing away from the first side (4a),
- at least one first conductor structure for superconducting an electrical current, the at least one conductive track being arranged on the first side (4a) of the substrate (4), wherein the at least one first conductor structure comprises a first metallic layer (30) of a first metal arranged on the first side (4a) of the electrically insulating substrate (4),
- a second metallic layer (31) of a different second metal, the second metallic layer (31) being arranged on the first metallic layer (30).

12. The electrically conducting structure according to claim 11, wherein the first metallic layer (30) is only partially overlapped by the second metallic layer (31) so that the first metallic layer (30) comprises an exposed portion (300).

13. The electrically conducting structure according to claim 11 or 12, wherein at least one second conductor structure (40a) is arranged on the first side (4a) of the electrically insulating substrate (4), wherein particularly the at least one first conductor structure and the at least one second conductor (40a) structure abut each other by a butt joint.

14. The electrically conducting structure according to claims 11 to 13 wherein the second metallic layer (31) and/or said at least one second conductor structure (40a) on the first side (4a) is covered by a plated metal layer (7).

15. The electrically conducting structure according to one of the claims 11 to 14, wherein the first metal is one of: niobium (Nb), titanium (Ti); and/or wherein the second metal is copper (Cu); and/or wherein the at least one second conductor structure (40a) essentially consists of or comprises Copper (Cu) or a copper alloy; and/or wherein the plated metal layer essentially consists of or comprises copper (Cu).
